# EUROPÄISCHE PATENTSCHRIFT

(11) **EP 1 302 876 B1**
(45) Veröffentlichungstag und Bekanntmachung des Hinweises auf die Patenterteilung: **31.12.2008**
(21) Anmeldenummer: 01124112.2
(22) Anmeldetag: 10.10.2001
(51) Int. Cl.: G06F 17/50

(54) **Verfahren zum rechnerunterstützen Entwerfen einer digitalen und/oder analogen Schaltung**
Computer aided design method of a digital and/or analog circuit
Méthode pour la conception assistée par ordinateur d'un circuit digital et/ou analogique

(43) Veröffentlichungstag der Anmeldung: 16.04.2003
(73) Patentinhaber: iC-Haus GmbH, D-55294 Bodenheim (DE)
(72) Erfinder: Riger, Raul, 74670 Forchtenberg (DE); Mandrella, Peter, 55299 Nackenheim (DE); Burkard, Ralf, 65321 Kemel (DE); Flocke, Heiner, Dr., 55294 Bodenheim (DE)
(74) Vertreter: Kampfenkel, Klaus

(56) Entgegenhaltungen:
- US-A- 5 303 161
- BENSOUIAH D A ET AL: "Analog Layout Generation: from Design Assistant to Automated Layout" CIRCUITS AND SYSTEMS, 1997. PROCEEDINGS OF THE 40TH MIDWEST SYMPOSIUM ON SACRAMENTO, CA, USA 3-6 AUG. 1997, NEW YORK, NY, USA,IEEE, US, 3. August 1997 (1997-08-03), Seiten 1038-1041, XP010272262 ISBN: 0-7803-3694-1
- MASATO MOGAKI ET AL: "COOPERATIVE APPROACH TO A PRACTICAL ANALOG LSI LAYOUT SYSTEM" PROCEEDINGS OF THE DESIGN AUTOMATION CONFERENCE. DALLAS, JUNE 14 - 18, 1993, PROCEEDINGS OF THE DESIGN AUTOMATION CONFERENCE (DAC), NEW YORK, IEEE, US, Bd. CONF. 30, 14. Juni 1993 (1993-06-14), Seiten 544-549, XP000371363 ISBN: 0-89791-577-1
- VAN DER PLAS G ET AL: "AMGIE-A synthesis environment for CMOS analog integrated circuits" IEEE TRANSACTIONS ON COMPUTER-AIDED DESIGN OF INTEGRATED CIRCUITS AND SYSTEMS, SEPT. 2001, IEEE, USA, Bd. 20, Nr. 9, Seiten 1037-1058, XP002193545 ISSN: 0278-0070

## Beschreibung

Die Erfindung betrifft ein Verfahren zum rechnerunterstützen Entwerfen einer digitalen und/oder analogen Schaltung sowie ein computerlesbares Speichermedium, auf welchem ein Programm zum rechnerunterstützen Entwerfen einer digitalen und/oder analogen Schaltung gespeichert ist.

Um den Arbeitsaufwand und auch die Kosten bei der Herstellung von elektronischen Schaltungen, beispielsweise integrierten Schaltungen oder gedruckte Schaltungen, reduzieren zu können, werden solche Schaltungen unter Einsatz von Rechnern entworfen. In der Regel umfasst ein rechnerunterstützer Schaltungsentwurf die Struktur- und Verhaltensbeschreibung unter Verwendung eines Schaltplans und ggfs. einer Netzliste, das Erstellen eines Layouts sowie die Herstellung einer Maske oder eines entsprechenden Datenträgers. Während, wie bereits erwähnt, die Struktur und Verhaltensweise einer Schaltung mittels eines Schaltplans beschrieben werden, dient das Layout zur Flächenplanung (floor planing) der zumeist rechteckförmigen Chipflächen, zum topologischen Entwurf (Plazierung der Bauelemente), zum geometrischen Entwurf der einzelnen Bauelemente sowie die Verdrahtung unter Berücksichtigung entsprechender Entwurfsregeln.

Um Schaltpläne sowohl für den Entwickler als auch für Softwaretools, wie z.B. Simulationsprogramme, in leicht verständlicher Form darstellen zu können, werden die in einen Schaltplan einzufügenden Bauelemente entsprechend ihrer Funktion angeordnet und zu Funktionsblöcken zusammengefasst. Ein Funktionsblock kann wiederum weitere Funktionsblöcke, auch Unterfunktionsblöcke genannt, enthalten, wodurch ein hierarchischer Schaltplan entsteht.

Beim Layout hingegen besteht das Bestreben, Bauelemente nach physikalischen und geometrischen Anforderungen anzuordnen und dann zu Zellen zusammenzufassen, um möglichst kleine Chipflächen und bestimmte physikalische Eigenschaften zu erreichen. Auch eine Zelle kann wiederum aus weiteren Zellen, sogenannten Unterzellen, bestehen. Hierdurch kann ein hierarchisch strukturiertes Layout entworfen werden.

Um dem Entwickler eine rechnerunterstützte Erstellung eines Layouts unter Zugrundelegung eines Schaltplans zu ermöglichen, ist es erforderlich, zwischen dem Schaltplan und dem Layout eine logische Zuordnung zu schaffen.

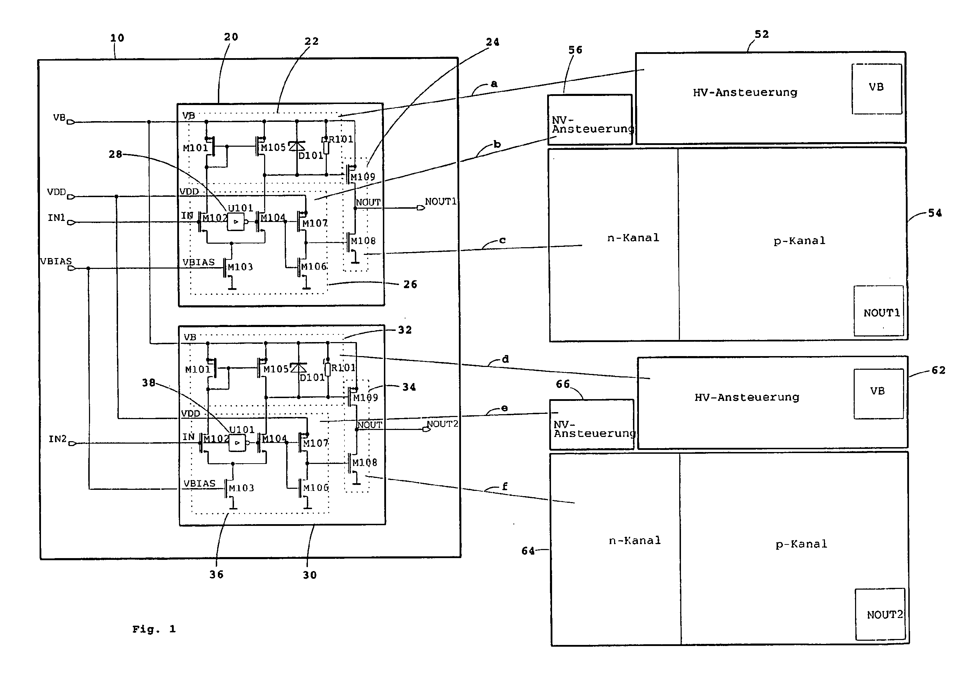

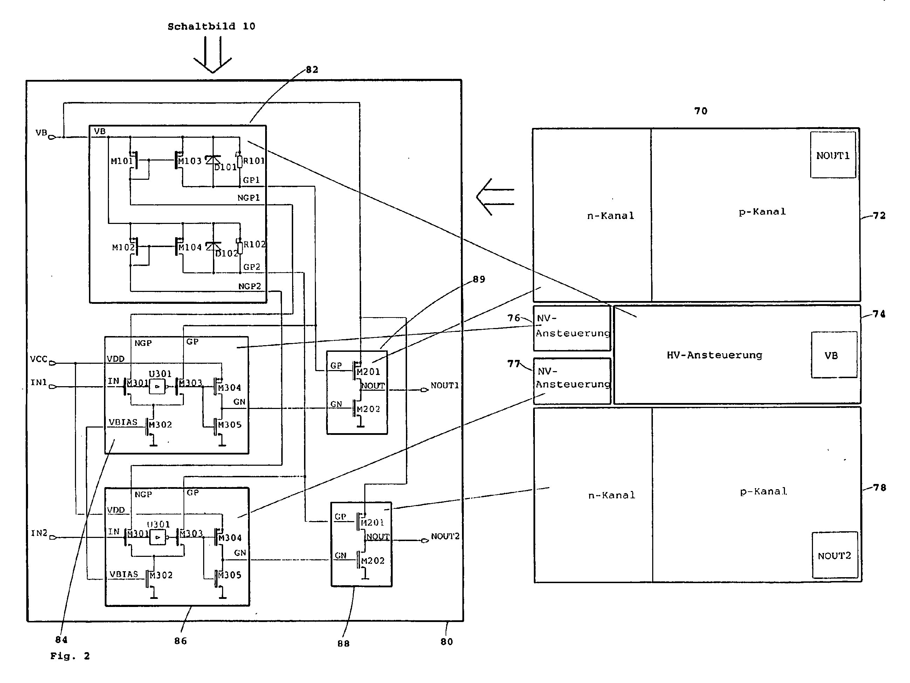

Eine Methode hierfür ist unter dem Begriff "Schematic Driven Layout" (Schaltplan-gesteuerter Layoutentwurf) bekannt. Bei dieser Methode wird jeder Zelle des Layouts genau ein Funktionsblock des Schaltplans eindeutig zugeordnet. Mit anderen Worten erzeugt diese Methode ein zellenstrukturiertes Layout, welches dem Funktionsblockstrukturierten Schaltplan entspricht. Aus dieser starren Vorschrift zur Abbildung von Funktionsblöcken auf die Layoutzellen ergeben sich zwei wesentliche Nachteile, die anhand der Figuren 1 und 2 näher erläutert werden.

1.) Wird, wie in Fig. 1 gezeigt, das Layout entsprechend dem vorgegebenen, funktional leicht verständlichen Schaltungsplan strukturiert, ist es nicht möglich, Zellen lediglich nach physikalischen und geometrischen Anforderungen anzuordnen, um möglichst kleine Chipflächen und bestimmte physikalische Eigenschaften zu erreichen. Figur 1 zeigt ein Beispiel für eine solch starre Zuordnungs- oder Abbildungsvorschrift zwischen Schaltplan und Layout, die auf dem bekannten "Schematic Driven Layout"-Ansatz beruht.

Fig. 1 zeigt beispielhaft einen hierarchisch strukturierten Schaltplan 10 eines Push-Pull-Hochvolttreiberpaars sowie ein stark vereinfachtes Layout, welches aus mehreren Zellen aufgebaut ist. Lediglich der einfachen Darstellung wegen ist nur eine Hierarchieebene des Layouts gezeigt. An dieser Stelle sei angemerkt, dass die für den Schaltplan 10 gewählte Anzahl an Hierarchieebenen und die gewählte Bezeichnung "Funktionsblock" und Unterfunktionsblock" lediglich beispielhaft ist.

Da dem eigentlichen Aufbau und der Arbeitsweise der Schaltung sowohl bei der Erläuterung des Standes der Technik als auch später bei der Beschreibung der Erfindung nur eine untergeordnete Bedeutung zukommt, wird auf eine detaillierte Beschreibung der Schaltung verzichtet. Der Schaltplan 10 des Push-Pull-Hochvolttreiberpaars enthält in der vierten höchsten Hierarchieebene zwei Funktionsblöcke 20 und 30, die jeweils einem Hochvolt-Inverter entsprechen. Jeder Funktionsblock enthält wiederum weitere Unterfunktionsblöcke, nämlich einen Unterfunktionsblock 22 bzw. 32, der einer Hochvolt-Ansteuerungseinrichtung entspricht, einen Unterfunktionsblock 24 bzw 34, der aus einem p-Kanal- und n-Kanal-Feldeffekttransistor besteht, sowie einen Unterfunktionsblock 26 bzw 36, der einer Niedervolt-Ansteuerungseinrichtung entspricht. Die Unterfunktionsblöcke 22, 24, 26, 32, 34 und 36 liegen allesamt in der dritten Hierarchiebene.

Die Unterfunktionsblöcke 22 und 32 enthalten im Einzelnen jeweils einen mit M101 bezeichneten Feldeffekttransistor, einen mit M105 bezeichneter Feldeffekttransistor, eine mit D101 bezeichnete Zenerdiode sowie einen mit R101 bezeichneten Widerstand. Weiterhin verfügen die Unterfunktionsblöcke 22 und 32 über einen Anschluss VB zum Anschalten der Betriebsspannung. Wie bereits erwähnt, sind in den Unterfunktionsblöcken 24 und 34 jeweils ein n-Kanal-Feldeffekttransistor M108 sowie ein p-Kanal-Feldeffekttransistor M109 angeordnet, die das Ausgangssignal NOUT1 bzw NOUT2 liefern. Die Unterfunktionsblöcke 26 und 36 enthalten jeweils vier n-Kanal-Feldeffekttransistoren M102, M103, M104 und M106, einen p-Kanal-Feldeffekttransistor M107 sowie ein zwischen die Gate-Elektroden der Feldeffekttransistoren M102 und M104 geschaltetes NAND-Gatter 28 bzw. 38, welches in der zweiten Hierarchieebene des Schaltplans 10 liegt. An die Gateelektrode des Feldeffekttranssitors M102 des Unterfunktionsblocks 26 wird das Eingangssignal IN1 angelegt, während das Eingangssignal IN2 der Gateelektrode des Feldeffekttranssitors M102 des Unterfunktionsblocks 36 zugeführt wird. Eine Vorspannung VBIAS wird sowohl an die Gateelektrode des Feldeffekttransistors M103 des Unterfunktionsblocks 26 als auch an die Gateelektrode des Feldeffekttransistors M103 des Unterfunktionsblocks 36 angelegt. Ein Spannungspotential VDD wird sowohl an die Drainelektrode des Feldeffekttransistors M107 des Unterfunktionsblocks 26 als auch an die Drainelektrode des Feldeffekttransistors M107 des Unterfunktionsblocks 36 angelegt.

Die in den Unterfunktionsblöcken enthaltenen einzelnen Widerstände, Feldeffekttransistoren und Dioden liegen in der untersten Hierarchieebene. Es ist jedoch allgemein bekannt, Schaltungen durch hierarchisch strukturierte Schaltpläne darzustellen. Wie man sich leicht vorstellen kann, bildet der hierarchisch aufgebaute Schaltplan 10 eine Baumstruktur, wobei die unterste Ebene, wie bereits erwähnt, die aktiven und passiven Bauelemente enthält, die in mehreren verschiedenen Funktionsblöcken oder Unterfunktionsblöcken angeordnet werden können. Sowohl die Bauelemente der untersten Hierarchieebene als auch die Funktionsblöcke oder Unterfunktionsblöcke können als Funktionseinheiten in entsprechenden Bibliotheken abgelegt sein.

Das in Fig. 1 dargestellte Layout ist in Zellen unterteilt, die jeweils eindeutig den Unterfunktionsblöcken des Schaltplans 10 zugeordnet sind. Hierbei sind der Unterfunktionsblock 22 der Zelle 52, der Unterfunktionsblock 26 der Layoutzelle 56 und der Unterfunktionsblock 24 der Layoutzelle 54 zugeordnet. Der Unterfunktionsblock 32 des Funktionsblocks 30 ist eindeutig der Layoutzelle 62 zugeordnet, wohingegen der Unterfunktionsblock 36 eindeutig der Funktionszelle 66 und der Unterfunktionsblock 34 der Layoutzelle 64 zugeordnet sind. Der Spannungsanschluss VB, der sowohl mit dem Unterfunktionsblock 22 als auch mit dem Unterfunktionsblock 34 verbunden ist, ist in den beiden Layoutzellen 52 und 62 vorgesehen. Der Ausgangsanschlusskontakt NOUT1 ist in der Layoutzelle 54 angeordnet, wohingegen Ausgangsanschlusskontakt NOUT2 der Layoutzelle 64 zugeordnet ist. Aufgrund der starren Zuordnungssvorschrift können die Unterfunktionsblöcke und die dazugehörenden Bauelemente des Schaltplans 10 nur über die in Fig. 1 eingezeichneten Verbindungslinien a bis f auf die jeweiligen Layoutzellen abgebildet werden. Mit anderen Worten können nur Bauelemente eines einzigen Unterfunktionsblocks in einer eindeutig zugeordneten Layoutzelle angeordnet und gemäß einer in Bezug auf den Schaltplan abgespeicherten Netzliste elektrisch verbunden werden.

2.) Der Nachteil bei einem Schaltplan-gesteuerten Layoutentwurf das Layout nicht nach physikalischen und geometrischen Anforderungen optimal entwerfen zu können, kann auch umgangen werden. Hierzu wird ausgehend vom Schaltplan nach Fig. 1 ein hinsichtlich der physikalischen und geometrischean Anforderungen optimiertes Layout mit Zellen entworfen und anschließend der in Fig 1 dargestellte, funktional leicht verständliche Schaltplan 10 dem optimierten Layout angepasst.

Fig. 2 zeigt hierzu das nach physikalischen und geometrischen Anforderungen optimierte Layout 70 und den daran angepassten Schaltplan 80, der dem Schaltplan 10 entspricht. Dem optimierten Layout liegt die physikalische Kenntnis zugrunde, dass die in den Funktionsblöcken 20 und 30 angeordneten Unterfunktionsblöcke 22 bzw. 32, die der Hochvolt-Ansteuerung des Push-Pull-Hochvolttreiberpaars entsprechen, in einer gemeinsamen Layoutzelle 74 mit einem gemeinsamen Anschlusskontakt VB angeordnet werden können. Im Übrigen entsprechen die Zellen 72, 76, 77 und 78 den Zellen 54, 56, 66 bzw. 64 nach Fig. 1.

Der an das optimierte Layout 70 angepasste Schaltplan 80 weist einen Funktionsblock 82 auf, der die Unterfunktionsblöcke 22 und 32 aus dem Schaltplan 10 nach Fig. 1 enthält. Der Funktionsblock 84 des modifizierten Schaltplans 80 enthält die Niedervolt-Ansteuerungseinrichtung, d. i der Unterfunktionsblock 26 im Schaltplan 10, und der Funktionsblock 86 enthält die Niedervolt-Ansteuerungseinrichtung, d. i der Unterfunktionsblock 36 im Schaltplan 10.Die beiden Funktionsblöcke 88 und 89 enthalten die Verstärkerstufe des Unterfunktionsblocks 24 bzw. 34. Der so modifizierte Schaltplan kann trotz der starren 1-zu-1-Abbildungsvorschrift der "Schematic-driven-Layout"-Methode auf das optimierte Layout abgebildet werden.

Allerdings ist das Modifizieren eines in herkömmlicherweise erstellten und funktional leicht lesbaren Schaltplans in einen weiteren, an ein optimiertes Layout angepassten Schaltplan fehleranfällig und führt zudem zu einer ineffizienten Arbeitsweise.

In dem Aufsatz "Analog Layout Generation: from Design Assistant to Automated Layout" CIRCUITS AND SYSTEMS, 1997. PROCEEDINGS OF THE 40^{th} MIDWEST SYMPOSIUM ON SACRAMENTO, CA, USA 3-6 AUG: 1997, NEW YORK, NY, USA, IEEE, US, 3. August 1997 (1997-08-03, Seiten 1038-1041, XP010272262 ISBN: 0-7803-3694-1 beschrieben Bensouiah D. A. et al. ein Verfahren gemäß dem Oberbegriff des Anspruchs 1.

Der Erfindung liegt daher die Aufgabe zugrunde, das eingangs erwähnte Verfahren zum rechnerunterstützen Entwerfen einer digitalen und/oder analogen Schaltung derart zu verbessern, dass unter Zugrundelegung eines funktional leicht verständlichen Schaltplans ein hinsichtlich physikalischer und geometrischer Anforderungen optimiertes Layout hergestellt werden kann.

Der Kerngedanke der Erfindung ist darin zu sehen, die starre Zurodnungsvorschrift zwischen Funktionsblöcken und den dazugehörenden Bauelementen eines Schaltplans und den Zellen eines Layouts aufzuheben und statt dessen eine frei wählbare Zuordnung von Bauelementen und Funktionsblöcken zu beliebigen Zellen eines Layouts zu ermöglichen. Sowohl Layout als auch Schaltplan können hierbei hierarchisch entworfen werden.

Hierzu wird ein Verfahren zum rechnerunterstützten Entwerfen einer digitalen und/oder analogen Schaltung bereitgestellt, nach dem ein Schaltplan erstellt wird, wobei wenigstens einige der in den Schaltplan einzufügenden Bauelemente zu Funktionsblöcken zusammengefasst werden. An dieser Stelle sei erwähnt, dass unter Bauelementen vorzugsweise elektronische passive und aktive Bauelemente, wie zum Beispiel Transistoren, Dioden, Widerstände und Kapazitäten zu verstehen sind. Ferner wird ein Layout erstellt, welches in Zellen unterteilt wird wobei die Layoutzellen in Abhängigkeit von der Funktionalität der durch den Schaltplan festgelegten Schaltung und von Entwurfsregeln, die vorbestimmten physikalischen und geometrischen Anforderungen genügen, definiert werden und verschiedene Funktionsblöcke (20, 30) oder Teile verschiedener Funktionsblöcke (22, 32) in einer vorbestimmten Layoutzelle (74) angeordnet werden können. Zwischen dem Schaltplan und dem Layout wird eine logische Zuordnung hergestellt, wobei die in den Schaltplan eingefügten Bauelemente oder Teile der Bauelemente frei ausgewählt und in einer beliebigen oder in mehreren Layoutzellen angeordnet werden können. Die frei wählbare Zuordnung von Bauelementen, Teilen von Bauelementen, Funktionsblöcken und Teilen von Funktionsblöcken zu einer Layoutzelle wird dadurch erreicht, dass zunächst in an sich bekannter Weise den Bauelementen und den Funktionsblöcken innerhalb des erstellten Schaltplans Attribute, insbesondere Adressen (Namen), schaltungsbezogene und physikalische Parameter zugeordnet werden. Beim Anordnen der Bauelemente in einer Layoutzelle wird neben dem zum Bauelement gehörenden Attribut ggf. auch das Attribut des Funktionsblocks, in dem dieses Bauelement enthalten ist, gespeichert. Anhand der gespeicherten Attribute wird schließlich eine logische Zuordnung zwischen der Layoutzelle und dem entsprechenden Teil des Schaltplanes hergestellt, so dass in der Layoutzelle die im entsprechenden Teil des Schaltplans definierten Verbindungen zwischen den Bauelementen erzeugt werden können.

Um große und komplexe Schaltungen überschaubar machen und leicht verständlich darstellen zu können, werden hierarchisch entworfene Schaltpläne verwendet, die hierarchisch gestaffelte Funktionsblöcken enthalten. Solche Funktionsblöcke können zum Beispiel Speicher, PLAs, Zähler, ALU, Register, Gatter, 1-Bit-Register und einfache Addierer enthalten. Derartige Funktionsblöcke können zusammen mit individuellen Bauelementen in Bibliotheken zur Wiederverwendung abgelegt werden.

In ähnlicher Weise kann auch das Layout hierarchisch gestaffelte Zellen enthalten.

Um Speicherplatz einzusparen, kann wenigstens einer Layoutzelle die Adresse eines Funktionsblocks fest zugeordnet werden. Auf diese Weise wird vermieden, dass beim Anordnen der Bauelemente, die aus dem fest zugeordneten Funktionsblock stammen, in der Layoutzelle die Adresse des Funktionsblocks zu jedem Bauelement gespeichert werden muss.

Das oben angegebene technische Problem wird ebenfalls durch ein computerlesbares Speichermedium gelöst, auf welchem ein Programm zum rechnerunterstützen Entwerfen einer digitalen und/oder analogen Schaltung gemäß oben definiertem Verfahren gespeichert ist.

Die Erfindung wird nachfolgend anhand eines Ausführungsbeispiels in Verbindung mit den Zeichnungen näher erläutert. Es zeigen:
- Fig. 1: den Schaltplan und das Layout eines Push-Pull-Hochvolttreiberpaars, wobei der Schaltplan mit Hilfe des bekannten "Schematic-driven-Layout"-Verfahrens starr auf das Layout abgebildet wird,
- Fig. 2: den Schaltplan nach Fig. 1, einen modifizierten Schaltplan und ein optimiertes Layout, wobei der modifizierte Schaltplan mit Hilfe des bekannten "Schematic-driven-Layout"-Verfahrens starr auf das optimierte Layout abgebildet wird,
- Fig. 3: den Schaltplan nach Fig. 1 und das optimierte Layout nach Fig. 2, wobei erfindungsgemäß der Schaltplan mit Hilfe einer flexiblen Abbildungsvorschrift auf das optimierte Layout abgebildet wird.

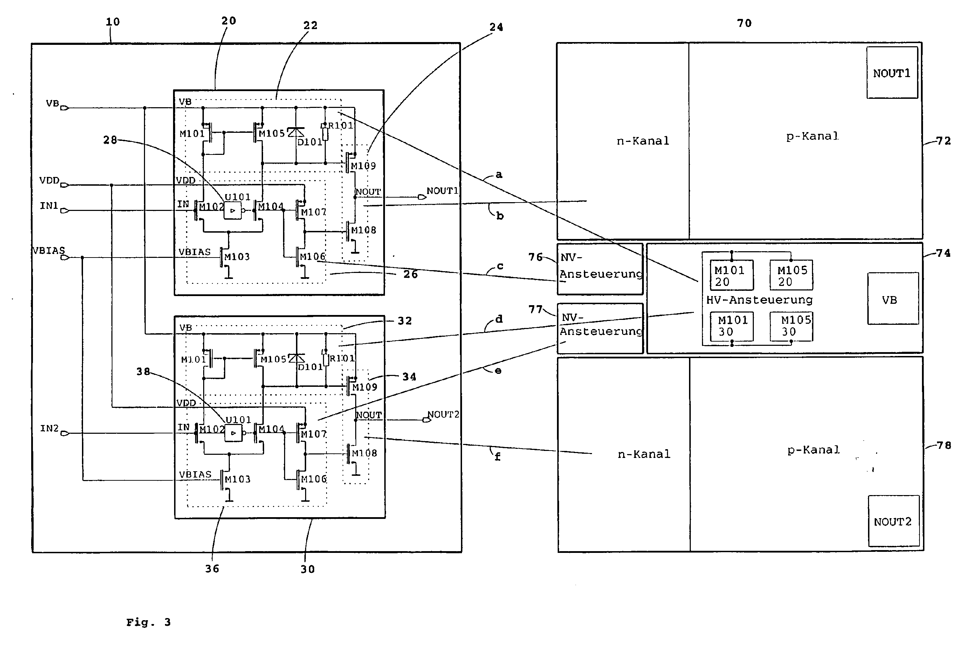

Anhand von Fig. 3 wird nachfolgend erläutert, wie unter Zugrundelegung eines nach funktionellen Gesichtpunkten und daher leicht lesbaren Schaltplans ein gemäß physikalischen und geometrischen Anforderungen optimiertes Layout entworfen werden kann. Ausgangspunkt ist der in Fig. 1 dargestellte Schaltplan 10, der ein Push-Pull-Hochvolttreiberpaar in symbolischer Schreibeweise darstellt. Der Schaltplan 10 wurde beispielsweise mit Hilfe eines bekannten graphischen Editors erstellt. Zu dem Schaltplan 10 kann eine Netzliste abgespeichert sein, die neben der strukturellen Beschreibung auch die Verfahrens- oder Funktionsweise der durch den Schaltplan wiedergegebenen Schaltung enthält. Den einzelnen Bauelementen, Funktionsblöcke 20 und 30 und Unterfunktionsblöcken 22 bis 38 sind neben Adressen oder Namen auch schaltungstechnische und physikalische Parameter zugeordnet. Schaltungstechnische Parameter definieren beispielsweise die Verbindungspunkte und Verbindungslinien zu anderen Bauelementen, wohingegen physikalische Parameter physikalische Größen oder Kennlinien zur Dimensionierung der Bauelemente sind. Der Einfachheit halber sei angenommen, dass die verwendeten Bezugszeichen den Adressen der Funktionsblöcke und Unterfunktionsblöcke entsprechen. Auf der rechten Seite der Fig. 3 ist das optimierte Layout nach Fig. 2 dargestellt, in dem die Zellen nach physikalischen und geometrischen Anforderungen erzeugt worden sind. Die logische, frei wählbare Zuordnung zwischen Funktionsblöcken, Unterfunktionsblöcken und Bauelementen des Schaltplans 10 und den Layoutzellen ist durch die Verbindungslinien a bis f angedeutet. Der Kerngedanke der vorliegenden Erfindung wird in Verbindung mit der Zelle 74 näher erläutert. Aufgrund schaltungstechnischer, physikalischer und geometrischer Anforderungen hinsichtlich des Entwurfs eines Push-Pull-Hochvolttreiberpaars, ist es möglich, die Zelle 74 so zu gestalten, dass die in den Funktionsblöcken 22 und 32 der Funktionsblöcke 20 bzw. 30 zusammengefassten Hochvolt-Ansteuerungseinrichtungen gemeinsam auf einem Chip und somit in der Layoutzelle 74 angeordnet werden können. Aufgrund der freien Zuordnung zwischen Bauelementen, Unterfunktionsblöcken und Funktionsblöcken und Zellen kann der Schaltplan auf das Layout 70 abgebildet werden, ohne dass der Schaltplan 10 an das optimierte Layout angepasst werden muss, wie dies nach dem in Fig. 2 gezeigten bekannten "Schematic-driven-Layout"-Verfahren notwendig ist.

Vielmehr genügt es, die Bauelemente des Unterfunktionsblocks 22 des Funktionsblocks 20 sowie die Bauelemente des Unterfunktionsblocks 32 des Funktionsblocks 30 mittels eines grafischen Editors in der Zelle 74 anzuordnen. Dies wird softwaremäßig dadurch erreicht, dass für die in der Zelle 74 angeordneten Bauelemente neben dem eigenen Namen auch der Name des jeweiligen Funktionsblocks oder Unterfunktionsblocks gespeichert werden. Der einfacheren Darstellung wegen sei angenommen, dass zunächst nur die Transistoren M101 und M105 aus dem Unterfunktionsblock 22 des Funktionsblocks 20 sowie die Transistoren M101 und M105 aus dem Unterfunktionsblock 32 des Funktionsblocks 30 in der Zelle 74 eingefügt worden sind. Auf Softwareebene bedeutet dies, dass bezüglich der Zelle 74 neben den Namen oder Adressen der Bauelemente M101 und M105 beispielsweise der Name des Funktionsblocks 20 oder 30 gespeichert wird, je nach dem, in welchem Funktionsblock die Bauteile enthalten sind. Mit Hilfe der gespeicherten Adressen der einzelnen Bauelemente und des dazugehörenden Funktionsblocks kann eine flexible logische Zuordnung zwischen der Zelle 74 und den Funktionsblöcken 20 und 30 hergestellt und die im Schaltplan definierten Verbindungen zwischen diesen Bauelementen automatisch hergestellt und mit dem Anschlusskontakt VB verbunden werden. Dies ist in der Zelle 74 nach Fig. 3 dargestellt. Anschließend werden die übrigen Bauelemente aus dem Unterfunktionsblock 22 und dem Unterfunktionsblock 32 in der Zelle 74 angeordnet, wobei aufgrund der erfolgten Zuordnung die entsprechend im Schaltbild definierten Verbindungen auch zwischen diesen Bauelementen erzeugt werden. In ähnlicher Weise werden die Bauelemente des Funktionsblocks 24 in die Zelle 72, die Bauelemente des Funktionsblocks 26 in die Zelle 76, die Bauelemente des Funktionsblocks 36 in die Zelle 77 und die Bauelemente des Funktionsblocks 34 in die Zelle 78 eingesetzt und die dazugehörenden Attribute gespeichert. Unter Zuhilfenahme der in den jeweiligen Zellen abgelegten Attributen kann dann wiederum eine logische Zuordnung zwischen den Funktions- und Unterfunktionsblöcken und den entsprechenden Zellen im Layout hergestellt und die in den entsprechenden Abschnitten des Schaltplans definierten Verbindungen zwischen den einzelnen Bauelementen aufgebaut werden.

Mit Hilfe dieses sogenannten Schaltplan-geführten Layoutentwurfs (Schematic guided Layout) ist es somit möglich, a) einen Funktionsblock auf mehrere Layoutzellen zu verteilen, b) wie in Fig. 3 gezeigt, Bauelemente oder Unterfunktionsblöcke aus verschiedenen Funktionsblöcken, in unserem Beispiel den Funktionsblöcken 20 und 30, auf eine Layoutzelle, in unserem Fall die Layoutzelle 74, abzubilden, c) Teile eines Bauelementes, beispielsweise der Kollektor eines Transistors, in mehreren Layoutzellen anzuordnen, und d) eine Layoutzelle mehrmals im Layout zu verwenden, wobei diese Zelle jeweils Teile verschiedener Funktionsblöcke enthalten kann.

Dank dieses Verfahrens ist es möglich, aus einem nach funktionellen Gesichtspunkten erstellten und somit ohne weiteres lesbaren Schaltplans ein nach physikalischen und geometrischen Anforderungen optimiertes Layout zumindest teilweise automatisiert unter Zugrundelegung des Schaltplans zu entwerfen.

Das Verfahren kann auch als Programm auf einem computerlesbaren Speichermedium abgelegt sein.

## Patentansprüche

1. Verfahren zum rechnerunterstützten Entwerfen einer digitalen und/oder analogen Schaltung mit folgenden Verfahrensschritten:
Erstellen eines Schaltplans (10), wobei wenigstens einige der in den Schaltplan (10) einzufügenden Bauelemente (M101, M105, D101, R101; M102, M103, M104, M106, M107; M109, M108) zu Funktionsblöcken (20, 22, 24, 26; 30, 32, 34, 36) zusammengefasst werden;
Erstellen eines Layouts (70), welches in Zellen (72, 74, 76, 77, 78) unterteilt wird, wobei
die Layoutzellen in Abhängigkeit von der Funktionalität der durch den Schaltplan festgelegten Schaltung und von Entwurfsregeln, die vorbestimmten physikalischen und geometrischen Anforderungen genügen, definiert werden und verschiedene Funktionsblöcke (20, 30) oder Teile verschiedener Funktionsblöcke (22, 32) in einer vorbestimmten Layoutzelle (74) angeordnet werden können; Herstellen einer logischen Zuordnung zwischen dem Schaltplan (10) und dem Layout (70), wobei die in den Schaltplan (10) eingefügten Bauelemente (M101, M105, D101, R101; M102, M103, M104, M106, M107; M109, M108) oder Teile der Bauelemente frei ausgewählt und in einer beliebigen oder in mehreren Layoutzellen (72, 74, 76, 77, 78) angeordnet werden,
**dadurch gekennzeichnet, dass**
den Bauelementen (M101, M105, D101, R101; M102, M103, M104, M106, M107; M109, M108) und den Funktionsblöcken (20, 22, 24, 26; 30, 32, 34, 36) innerhalb des erstellten Schaltplans (10) Attribute, insbesondere Adressen oder Namen, schaltungbezogene und physikalische Parameter zugeordnet werden, dass
für jedes in einer Layoutzelle (74) angeordnete Bauelement (M101, M105) die Adresse oder der Name des Bauelements und gegebenenfalls die Adresse oder der Name des Funktionsblocks (20, 30), in dem dieses Bauelement enthalten ist, gespeichert wird, und dass
anhand der gespeicherten Adressen oder Namen eine logische Zuordnung zwischen der Layoutzelle (74) und dem entsprechenden Teil des Schaltplans hergestellt wird, so dass in der Layoutzelle die im entsprechenden Teil des Schaltplans definierten Verbindungen zwischen den Bauelementen erzeugt werden können.

2. Verfahren nach Anspruch 1,
**dadurch gekennzeichnet, dass**
der Schaltplan (10) hierarchisch gestaffelte Funktionsblöcke (20, 30; 22, 24, 26, 32, 34, 36; 28) und das Layout hierarchisch gestaffelte Zellen enthalten kann.

3. Verfahren nach Anspruch 1 oder 2,
**dadurch gekennzeichnet,**
**dass** wenigstens einer Layout-Zelle die Adresse eines Funktionsblocks fest zugeordnet wird.

4. Verfahren nach einem der Ansprüche 1 bis 3,
**dadurch gekennzeichnet, dass**
Bauelemente und/oder Funktionsblöcke in einer Bibliothek zur Wiederverwendung abgelegt werden.

5. Computerlesbares Speichermedium, auf welchem ein Programm zum rechnerunterstützten Entwerfen einer digitalen und/oder analogen Schaltung nach einem der Ansprüche 1 bis 4 gespeichert ist.

## Claims

1. Method for the computer-aided design of a digital and/or analogue circuit having the following method steps:
generating a circuit diagram (10), wherein at least some of the components (M101, M105, D101, R101; M102, M103, M104, M106, M107; M109, M108) to be inserted into the circuit diagram (10) are combined to form function blocks (20, 22, 24, 26; 30, 32, 34, 36);
generating a layout (70) which is divided into cells (72, 74, 76, 77, 78), wherein the layout cells are defined as a function of the functionality of the circuit established by the circuit diagram and of design rules which comply with predetermined physical and geometric requirements, and different function blocks (20, 30) or parts of different function blocks (22, 32) can be disposed in a predetermined layout cell (74);
producing a logical assignment between the circuit diagram (10) and the layout (70), wherein the components (M101, M105, D 101, R101; M102, M103, M104, M106, M107; M109, M108) or parts of the components inserted into the circuit diagram (10) are freely selected and are disposed in any one or several layout cells (72, 74, 76, 77, 78),
**characterised in that**
the components (M101, M105, D101, R101; M102, M103, M104, M106, M107; M109, M108) and the function blocks (20, 22, 24, 26; 30, 32, 34, 36) within the generated circuit diagram (10) are allocated attributes, in particular addresses or names, parameters relating to the circuit and physical parameters, **in that**
for each component (M101, M105) disposed in a layout cell (74), the address or name of the component and possibly the address or name of the function block (20, 30) in which this component is contained is stored, and **in that**
a logical assignment between the layout cell (74) and the corresponding part of the circuit diagram is produced using the stored addresses or names so than the connections between the components as defined in the corresponding part of the circuit diagram can be produced in the layout cell.

2. Method as claimed in Claim 1, **characterised in that**
the circuit diagram (10) can contain hierarchically graded function blocks (20, 30; 22, 24, 26, 32, 34, 36; 28) and the layout can contain hierarchically graded cells.

3. Method as claimed in Claim 1 or 2, **characterised in that**
the address of a function block is permanently assigned to at least one layout cell.

4. Method as claimed in any one of Claims 1 to 3, **characterised in that**
components and/or function blocks are stored in a library for re-use.

5. Computer-readable storage medium, on which a program for the computer-aided design of a digital and/or analogue circuit as claimed in any one of Claims 1 to 4 is stored.

## Revendications

1. Procédé de conception assistée par ordinateur d'un circuit numérique et/ou analogique, comportant les étapes de procédé consistant à :
établir un schéma de montage (10), au moins certains des composants (M101, M105, D101, R101 ; M102, M103, M104, M106, M107 ; M109, M108) à insérer dans le schéma de montage (10) étant réunis en blocs fonctionnels (20, 22, 24, 26 ; 30, 32, 34, 36) ;
établir une maquette (70) qui est subdivisée en cellules (72, 74, 76, 77, 78), les cellules de la maquette étant définies d'après les fonctionnalités du circuit déterminé par le schéma de montage et des règles de conception qui répondent à des exigences physiques et géométriques prédéterminées et des blocs fonctionnels différents (20, 30) ou des parties de blocs fonctionnels différents (22, 32) pouvant être placés dans une cellule prédéterminée (74) de la maquette ;
fixer une correspondance logique entre le schéma de montage (10) et la maquette (70), les composants (M101, M105, D101, R101 ; M102, M103, M104, M106, M107 ; M109, M108) insérés dans le schéma de montage (10) ou des parties des composants étant librement choisis et placés dans une cellule quelconque ou dans plusieurs cellules (72, 74, 76, 77, 78) de la maquette ;
**caractérisé en ce que** les composants (M101, M105, D101, R101 ; M102, M103, M104, M106, M107 ; M109, M108) et les blocs fonctionnels (20, 22, 24, 26 ; 32, 34, 36) sont associés au sein du schéma de montage (10) établi à des attributs, en particulier des adresses, des noms ou des paramètres physiques ou liés au circuit ;
**en ce que** l'on mémorise pour chacun des composants (M101, M105) placés dans une cellule (74) de la maquette l'adresse ou le nom du composant et éventuellement l'adresse ou le nom du bloc fonctionnel (20, 30) dans lequel est inclus ce composant ; et
**en ce que** l'adresse ou le nom mémorisé établit une correspondance logique entre la cellule (74) de la maquette et la partie correspondante du schéma de montage, si bien que l'on peut produire dans la cellule de la maquette les liaisons entre composants qui sont définies dans la partie correspondante du schéma de montage.

2. Procédé selon la revendication 1, **caractérisé en ce que** le schéma de montage (10) peut contenir des blocs fonctionnels (20, 30 ; 22, 24, 26, 32, 34, 36 ; 28) organisés hiérarchiquement et que la maquette peut contenir des cellules organisées hiérarchiquement.

3. Procédé selon la revendication 1 ou 2, **caractérisé en ce que** l'adresse d'un bloc fonctionnel est attribuée de manière fixe à au moins une cellule de la maquette.

4. Procédé selon l'une des revendications 1 à 3, **caractérisé en ce que** des composants et/ou des blocs fonctionnels sont déposés dans une bibliothèque afin d'être réutilisés.

5. Support de stockage lisible par ordinateur, sur lequel est mémorisé un programme de conception assistée par ordinateur d'un circuit numérique et/ou analogique selon l'une des revendications 1 à 4.
